(19) Europäisches Patentamt

European Patent Office

Office européen des brevets

(11) **EP 1 503 490 B1**

(12) **EUROPEAN PATENT SPECIFICATION**

(45) Date of publication and mention
of the grant of the patent:
**18.10.2006 Bulletin 2006/42**

(51) Int Cl.:
***H02M 3/00*** *(2006.01)*        ***H03F 1/22*** *(2006.01)*

(21) Application number: **03017431.2**

(22) Date of filing: **01.08.2003**

(54) **Current sensing circuit**

Stromfühlerschaltung

Circuit de détection de courant

(84) Designated Contracting States:
**DE FR GB IT**

(43) Date of publication of application:
**02.02.2005 Bulletin 2005/05**

(73) Proprietor: **Infineon Technologies AG**
**81669 München (DE)**

(72) Inventors:
• **Bernardon, Derek**
**9500 Villach (AT)**
• **Berger, Stefan**
**9551 Bodensdorf (AT)**
• **Labate, Francesco**
**9500 Villach (AT)**
• **Grillo, Sandro**
**9500 Villach (AT)**

(74) Representative: **Reinhard - Skuhra - Weise &**
**Partner**
**Postfach 44 01 51**
**80750 München (DE)**

(56) References cited:
**EP-A- 0 967 390**        **US-A1- 2002 180 489**

• **PATENT ABSTRACTS OF JAPAN vol. 1996, no.
08, 30 August 1996 (1996-08-30) & JP 08 093619
A (DIAMOND ELECTRIC MFG CO LTD), 9 April
1996 (1996-04-09)**
• **PATENT ABSTRACTS OF JAPAN vol. 2002, no.
08, 5 August 2002 (2002-08-05) & JP 2002 110986
A (FUJI ELECTRIC CO LTD), 12 April 2002
(2002-04-12)**

**EP 1 503 490 B1**

**Description**

The invention refers to a current sensing circuit for sensing a current flowing through a power diode. Such a circuit is disclosed in the japanese patent JP 809 36 19.

Power diodes are used in many different applications. For instance in most switched converter topologies power diodes are required. In particular cases it is required to measure the current flowing through these diodes in a accurate manner.

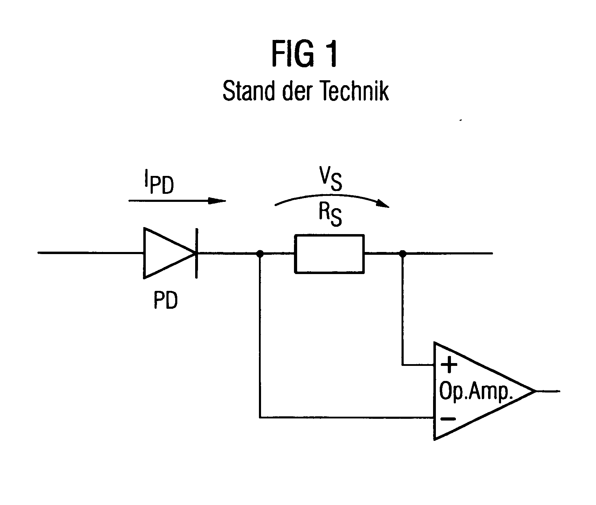

Figure 1 shows a sensing circuit for sensing a current flowing through a power diode according to the state of the art. A sensing resistor $R_S$ is connected to the power diode PD in series. The sensing resistor RS is an internal integrated resistor or an external resistor. The current flowing through the power diode $PDI_{PD}$ flows through the sensing registor and generates a drop voltage VS which is applied to the input terminals of an operation amplifier sensing the drop voltage.

The sensing circuit according to the state of the art as shown in figure 1 has several disadvantages. Since an additional sensing resistor has to be added the power dissipation is increased, hence decreasing efficiency. Further due to the limits of the voltage sensing operation amplifier the range of the sensed current is also limited. A further disadvantage is that the sensing resistor RS requires trimming.

Accordingly it is the object of the present invention to provide a current sensing circuit for sensing a current flowing through a power diode which has a minimum power dissipation.

This object is achieved by a current sensing circuit for sensing a current flowing through a power diode having the features of main claim 1.

The invention provides a current sensing circuit for sensing a current flowing through a power diode PD having a sense diode SD matched with said power diode PD wherein the sense diode SD comprises an anode portion and a cathode portion and delivers a sense diode current which is proportional to the current flowing through said power diode PD, an operation amplifier having a first input connected to the cathode portion of said sense diode SD, a second input connected to the cathode portion of said power diode PD and an output,
a current mirror circuit for mirroring the sense diode current, wherein said current mirror circuit comprises
a first mirror transistor and a second mirror transistor, each having a basis which is connected to the output of said operation amplifier,
wherein the collector of the first mirror transistor is connected to the cathode portion of the sense diode SD and
wherein the collector of said second mirror transistor supplies a mirrored sense diode current.

In a preferred embodiment the power diode comprises a plurality of power diode cells which are connected in parallel to each other.

In a first embodiment the sense diode SD is formed by at least one power diode cell.

In a second embodiment of the present invention the sense diode SD is located close to the power diode PD.

The operation amplifier is preferably an Auto-Zero-Operational-Amplifier.

This has the advantage that a possible error due to offset is canceled.

In a preferred embodiment the emitters of said mirror transistors are connected via resistors to a reference potential.

In a preferred embodiment the collectors of said mirror transistors are connected to cascode-transistor.

The cascode-transistor preferably each have a gate terminal connected to a biasing voltage source.

In a preferred embodiment the power diode is a free wheeling power diode connected in parallel to an inductive load L.

In a preferred embodiment the inductive load L is connected to a switching power transistor.

In a first embodiment the inductive load L is a linear inductive load.

In an alternative embodiment the inductive load L is an non linear inductive load.

In a preferred embodiment the average current $I_{avg}$ flowing through the switching power transistor to the inductive load L is controlled by an average current control circuit which controls the duty cycle of said switching power transistor.

In a preferred embodiment a first sensing transistor is integrated in said switching power transistor for sensing the actual current flowing through said switching power transistor in an ON phase of said transistor.

In a preferred embodiment a second sensing transistor is integrated in said switching power transistor.

In a preferred embodiment the average current control circuit comprises a loop current regulation circuit connected to the first sensing transistor and to said second sensing transistor.

The current regulation loop comprises in a preferred embodiment
a comparator circuit for comparing the current flowing through said first sensing transistor and the current flowing through said second sensing transistor,
a first counter which counts up a digital counter value I* as long as the comparator circuit indicates that current flowing through said first sensing transistor is higher than the current flowing through said second sensing transistor,
a decoder which decodes the digital counter value and generates a proportional DC-voltage by adjusting a resistor through which a reference current is flowing,
an operation amplifier for generating in response to the DC-voltage an output current flowing to said second sensing transistor.

In a preferred embodiment the first counter is clocked with a clock signal CLK having a high clock frequency for oversampling.

In a preferred embodiment the digital counter value I* output by said first counter is sampled by a sample and hold circuit, wherein the sampled value represents the actual average current $I_{avg}$ flowing through said switching power sensing transistor.

In a preferred embodiment the sample and hold circuit is clocked with a pulse with modulated signal (PWM) having a low clock frequency.

In a preferred embodiment an interface is provided for inputting a desired average current $I_{DES}$.

In a further embodiment the actual average current $I_{avg}$ sampled by the sample and hold circuit and the desired average current $I_{DES*}$ input by means of said interface are supplied to a calculation unit which calculates a switch on time $T_{ON}*$ for the switching power transistor in response to the actual average current $I_{avg}*$ and the desired average current $I_{DES}*$.

In a preferred embodiment a driver circuit is provided which is connected to the gate of the switching power transistor and turns the power transistor off when a second counter reaches the switch on time $T_{ON}*$ calculated by the calculation unit.

In a further embodiment the second counter is clocked with said clock signal CLK.

In a still further embodiment during the ON phase of the switching power transistor the actual current flowing through said power transistor and through the inductive load L is sensed by said first sensing transistor and during the OFF phase of the switching power transistor the actual current flowing through the inductive load L is sensed by a sense diode SD.

In the following preferred embodiments of the current sensing circuit according to the present invention are described with reference to the enclosed figures.

Figure 1 shows a current sensing circuit according to the state of the art;

Figure 2 shows a first embodiment of the current sensing circuit according to the present invention;

Figure 3 shows a second embodiment of the current sensing circuit according to the present invention;

Figure 4 shows a current regulation loop for regulating an average current flowing through an inductive load L to which a power diode is connected in parallel;

Figure 5 shows timing diagrams for explaining the functionality of the current regulating loop as shown in figure 4;

Figure 6 shows a timing diagram to explain the functionality of the current regulation loop as shown in figure 4;

Figure 7 shows a current sensing circuit according to the present invention used for regulating the average current flowing through a non linear inductive load connected in parallel to a power diode according to the present invention;

Figure 8 shows the signal timing diagram to explain the functionality of the circuit as shown in figure 7.

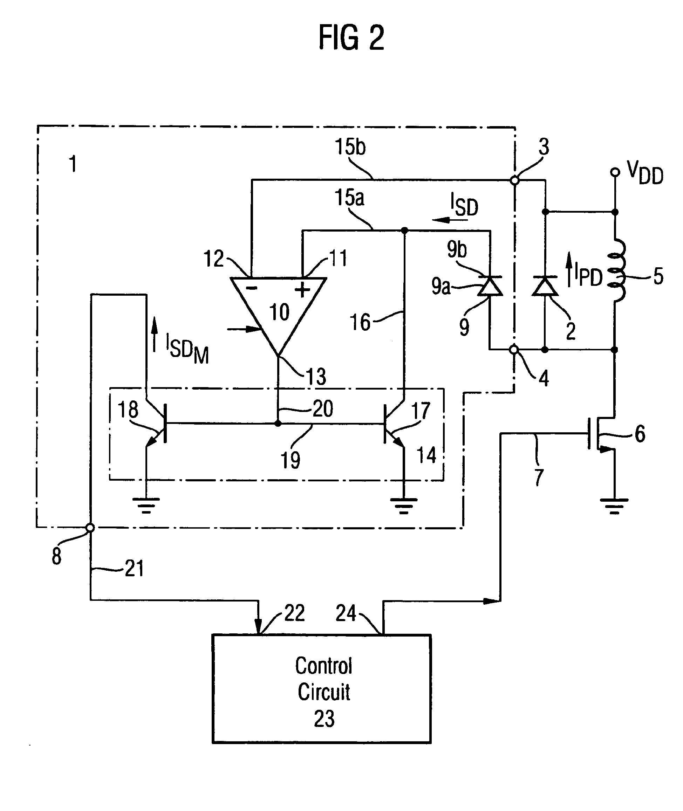

Figure 2 shows a preferred embodiment of the current sensing circuit 1 according to the present invention. The current sensing circuit 1 for sensing a current flowing through a power diode 2 has a first signal input 3 and a second signal input 4. The power diode 2 as shown in figure 2 is a free wheeling power diode connected in parallel to an inductive load 5. The inductive load 5 is connected to a power MOSFET 6 which is a P-MOSFET or an N-MOSFET. The power MOSFET 6 is provided for switching the inductive load 5. The gate of the power MOSFET is connected via a line 7 to a control circuit 23. The current sensing circuit 1 comprises an output 8 connected to said control circuit 23.

The current sensing circuit 1 comprises a sense diode 9 which is matched with said power diode 2. The power diode 2 has in one embodiment a plurality of power diode cells which are connected in parallel to each other. In a preferred embodiment the sense diode a is formed by at least one of these power diode cells. The current $I_{SD}$ flowing through the sense diode 9 is proportional to the current $I_{PD}$ flowing through the power diode 2. The current flowing through the sense diode 9 forms a fraction of the current flowing through the power diode 2.

(1)

$$I_{SD} = \frac{1}{K} I_{PD}$$

The sense diode 9 comprises an anode portion 9a a cathode portion 9b.

The current sensing circuit 1 further includes an operational amplifier 10 having a non inverting input 11, an inverting input 12 and an output 13. The operation amplifier 10 is supplied with a supply voltage $V_{DD}$ (not shown). The non inverting input 11 of the operation amplifier 10 is connected to the cathode portion 9b of the sense diode 9 via a line 15a. The inverting input 12 of the operation amplifier 10 is connected to the input 3 of the current sense circuit 1 via line 15b. The sense diode 9 delivers the sense diode current $I_{SD}$ which is proportional to the current $I_{PD}$ flowing through the power diode 2.

The current sensing circuit 1 further comprises a current mirror circuit 14 for mirroring the sense diode current $I_{SD}$. The operation amplifier 10 forces the cathode portion 9b of the sense diode to the same voltage at the cathode of the power diode 2 connected to input 3 of the current sensing circuit 1. Once both voltages are equal the forced current flowing via line 16 and via a first transistor 17 of said current mirror circuit 14 to ground GND is proportional to the current $I_{PD}$ flowing through the power diode 2.

The ratio k between the forced current $I_{SD}$ and the current $I_{PD}$ flowing through the power diode 2 is equivalent to the ratio of the number of cells of the sense diode 9 and the number of all cells of the power diode 2. The current mirror circuit 14 comprises the first transistor 17 and a second mirror transistor 18 wherein the basis of both transistors 17, 18 are connected to each other via a line 19. This line 19 is connected to the output terminal 13 of the operation amplifier 10 via a line 20. The current flowing through the first transistor 17 of the current mirror circuit 14 which is proportional to the current flowing through the power diode 2 is mirrored by the second transistor 18 of the current mirror circuit 17 to a mirrored sense diode current $I_{SDM}$. The mirrored sense diode current is also proportional to the original current $I_{SDM}$ flowing through the power diode 2. The mirrored sense diode current $I_{SDM}$ is supplied via output and a line 21 to an input 22 of the control circuit 23. The control circuit 23 generates a control signal which is supplied to via an output 24 and line 7 to the power switching transistor 6. The control circuit 23 generates in a preferred embodiment control pulse signal CRT2 for controlling the power MOSFET 6. The duty cycle of the path signal is controlled by the control circuit 23 in such a way that the average current $I_{avg}$ flowing through the load 5 corresponds to a desired current $I_{DES}$ which is input in a preferred embodiment by means of an interface connected to the control circuit 23. For regulating the average current $I_{avg}$ through the inductive load 5 by switching the power MOSFET 6 the control circuit 23 is supplied by the current sensing circuit 1 with the mirrored sense current $I_{SDM}$ which is proportional to the current $I_{PD}$ flowing through the power diode 2.

The sense diode 9 is located close to the power diode 2. Accordingly the sense diode 9 wears the same amount of heat as the power diode 2 in order to achieve the same temperature T over both diodes 2, 9. The sense diode 9 is located in a first embodiment within the power diode 2 to optimize matching between the sense diode 9 and the power diode 2. In a preferred embodiment the operation amplifier 10 is an Auto-Zero-Operational-Amplifier which forces the cathode of the sense diode 9 to have the same voltage as the cathode of the power diode 2. Since a small perturbation of the voltage across the diode causes a large perturbation in the current due to the exponential relationship an Auto-Zeroing Operation Amplifier is necessary to cancel possible errors due to offset.

The configuration as shown in figure 2 can be also used for diodes which are connected to ground i.e. a Buck Converter, by inverting the whole circuit. By adding the sense diode 9 which has the same temperature T as the power diode 2 because it is located within and near by the power diode 2 the circuit as shown in figure 2 causes a regulated current through the sense diode 9 to achieve the same voltage drop that is present on the power diode 2.

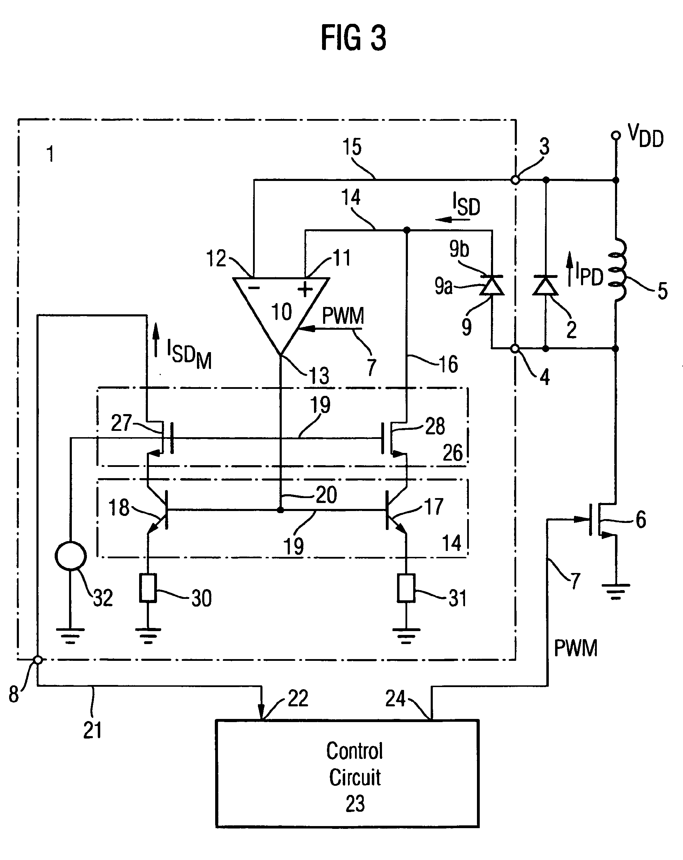

Figure 3 shows a preferred embodiment of the current sensing circuit 1 according to the present invention. In the embodiment as shown in figure 3 the collector terminals of mirror transistors 17, 18 are connected to a cascode stage 26 having a first MOSFET 27 and a second MOSFET 28. The gate terminals of both MOSFETS 27, 28 are connected to each other via a line 29. Further the current sensing circuit 1 according to the second embodiment as shown in figure 3 comprises resistors 30, 31 which are connected to the emitters of the mirror transistors 17, 18. The gate terminals of the N-MOS Transistor 27, 28 are connected to a biasing voltage source 32 generating a bias voltage. The cascode MOSFETS 27, 28 and the resistors 30, 31 are provided to improve matching of the mirroring transistors 17, 18. The current sensing circuit 1 according to the present invention as shown in figures 2, 3 does not use a resistor for measuring the current $I_{PD}$ flowing through the power diode 2. Consequently the power dissipation is minimized. The current sensed by the current sensing circuit 1 is used in the current regulating loops as shown in figures 2, 3 to control switching power MOSFET 6 in such a manner that the average current $I_{avg}$ through the inductive load 5 corresponds to a desired average current $I_{DES}$ which is input to the control circuit 23 via an interface.

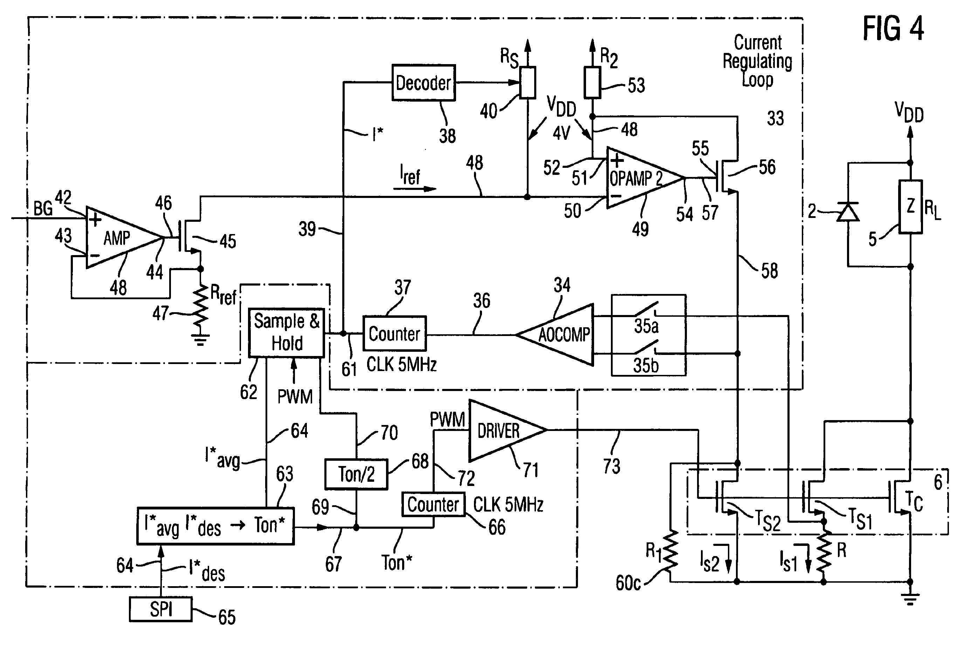

Figure 4 shows a current regulator for regulating the current through power MOSFET 6. The power MOSFET 6 is connected to the inductive load 5 to which a free wheeling power diode 2 is connected parallel. The free wheeling power diode 2 and the inductive load 5 are connected to a supply voltage terminal to which a supply voltage $V_{DD}$ of 48 V is applied. The inductive load 5 shown in figure 4 is a linear inductive load L. The purpose of the regulating circuit shown in figure 4 is to regulate the average current $I_{avg}$ flowing through the inductive load 5 accurately. Since the inductive load 5 is linear, the current flowing through the inductive load 5 during the time $I_{ON}$ when the power transistor 6 is switched on and the time $T_{OFF}$ when the power transistor 6 is switched off can be approximated by a straight line slope which depends on the value of the inductance L and the switching frequency $t_{switch}$ of the power MOSFET 6. In the embodiment shown in figure 4 the power MOSFET 6 comprises a switching transistor $T_0$ and two integrated sense transistors $T_{S1}$ and $T_{S2}$. The two sensing transistors $T_{S1}$ and $T_{S2}$ are provided for regulating the current flowing through the switching transistor $T_0$ of the power MOSFET 6. The average current control circuit shown in figure 4 controls the duty cycle of the switching power MOSFET $T_0$.

The duty cycle of the switching transistor $T_0$ is defined as the ratio between the time $T_{ON}$ when the power transistor 6 is switched on and the time period $T_{ON} + T_{OFF}$ of a switching cycle.

$$\text{Duty Cycle } = T_{ON}/\left(T_{ON} + T_{OFF}\right) \tag{2}$$

The first sensing MOSFET $T_{S1}$ is integrated in the switching MOSFET 6 for sensing the actual current I flowing through the power MOSFET 6 during the ON phase.

The average current $I_{avg}$ flowing through the load 5 is identical with the average current flowing through the switching transistor $T_0$ of the power transistor 6.

The current flowing through the sense MOSFET $T_{S1}$ and $T_{S2}$ are proportional to the actual current flowing through the switching transistor $T_0$. The average current control circuit as shown in figure 4 controls the current $I_{TS2}$ flowing through the second sense MOSFET $T_{S2}$ to follow the current $I_{TS1}$ flowing through the first sense MOSFET $T_{S1}$.

$$I_{TS1} = I_{TS2} \tag{3}$$

The average current control circuit comprises a current regulating loop 33 which is connected to the first sense MOSFET $T_{S1}$ and the second sense MOSFET $T_{S2}$. The current regulating loop 33 comprises a comparator circuit 34 connected to the sense MOSFET $T_{S1}$ and $T_{S2}$ via switches 35a, 35b which switch alternatively, i. e. when switch 35a is on switch 35b is off and vice versa. The comparator circuit 34 is provided for comparing the current $I_{TS1}$ flowing through the first sense MOSFET $T_{S1}$ and the current flowing through the second sense MOSFET $T_{S2}$. The comparator circuit 34 is an Auto-Zeroing Operational-Amplifier. The output of the comparator circuit 34 is connected via a line 36 to a first counter circuit 37 which is clocked by a clock signal CLK. The clock signal CLK has a high clock frequency of e.g. 5 MHz for oversampling. The counter circuit 37 counts up a digital counter value I* as long as the comparator circuit 34 indicates that the current $I_{TS1}$ flowing through the first sense MOSFET $T_{S1}$ is higher than the current $I_{TS2}$ flowing through the second sense MOSFET $T_{S2}$. The digital counter value I* is supplied to a decoder 38 via digital signal lines 39. The decoder 38 decodes the digital counter value I and generates a proportional DC voltage by adjusting a resistor 40 through which the reference current $I_{REF}$ is flowing.

The resistor 40 is formed in a preferred embodiment by a chain of resistors connected in series wherein the nodes between the resistors are connected to drain terminals of MOSFET transistors each having a gate terminal which is controlled by a digital control signal provided by the decoder. The source terminals of the MOSFET transistors are connected to the positive power supply voltage $V_{DD}$. By controlling the gate terminals of the MOSFET transistors it is possible to adjust the DC voltage drops at the resistor chain.

The reference current $I_{ref}$ flowing through the adjusted resistor 40 is generated by a reference current source comprising an operation amplifier 41 having a non inverting input terminal 42 and an inverting input terminal 43. A bandgap voltage is applied to the non inverting terminal 42. The operation amplifier 41 comprises an output 44 connected to the gate of a MOSFET 45 via a line 46. The MOSFET 45 has a drain terminal connected to ground GND via reference resistor 47. The other terminal of the MOSFET 45 supplies the reference current $I_{REF}$ to resistor 40 via a line 48. The current regulating loop 33 further comprises an operational amplifier 49 for generating in response to the DC voltage applied to the resistor 40 an output current flowing to the second sense MOSFET $T_{S2}$. The operation amplifier 41 comprises an inverting input 50 connected to the reference current line 48 and a non inverting input 51 connected via a line 52 to a further resistor 53 to which the supply voltage $V_{DD}$ is applied. The operational amplifier 49 comprises an output terminal 54 connected to the gate 55 of a MOSFET 56 via a line 57. The operation amplifier 49 controls the MOSFET 56 in such a way that the current $I_{TS2}$ is proportional to the DC voltage of the trimming resistor 40 and flows to the second sense MOSFET $T_{S2}$ through a current line 58. At a branching node 59 a resistor 60 is connected in parallel to the power MOSFET 6 which includes the integrated transistors $T_0$, $T_{S1}$, $T_{S2}$. The resistor 60 and the power MOSFET 6 are connected to a reference potential e.g. ground GND. The current regulating loop 33 comprising the operational amplifier 34, the counter 37, the decoder 38, the operation amplifier 49 and the MOSFET 56 and regulates the current $I_{TS2}$ flowing through the second sense MOSFET $T_{S2}$ to follow the current $I_{TS1}$ through the first sense MOSFET $T_{S1}$.

As long as the operation amplifier 34 indicates that the current $I_{TS2}$ is smaller than the current $I_{TS1}$ the counter 37 counts up with a very high oversampling frequency of e.g. 5 MHz. When the comparator circuit 34 indicates that the current $I_{TS2}$ is higher than the current $I_{TS1}$ the counter 37 stops counting.

The output of the counter 37 is connected via a line 61 to a sample and hold circuit 62. The digital counter value I* output by the counter 37 is sampled by the sample and hold circuit 62. The sampled value represents the actual average current $I_{AVG}$* flowing through the switching power MOSFET 6. The sample and hold circuit 62 is clocked with a second clock signal CLK2 having a comparatively low frequency of e.g. 4 KHz. The sampled actual average currents $I_{AVG*}$ is output to a calculation unit 63 for calculating a switch on time $T_{ON*}$ of the switching power MOSFET 6. The sample and hold circuit 62 is connected to the calculation unit 63 via lines 64.

The calculation unit 63 is further connected to a serial protocol interface 65 via lines 66. Via the serial protocol interface 63 the user can input a desired average current $I_{DES}$* for the power MOSFET 6. On the basis of actual sampled average current $I_{avg}$* and the desired current $I_{DES}$* the calculation unit 63 calculates the switch on time $T_{ON*}$ for the switching power MOSFET 6. The calculated switch on time $T_{ON*}$ is supplied to a second counter 66 via lines 67 and to a division circuit 68 via lines 69. The division circuit 68 divides the calculated switch on time $T_{ON*}$ by two and outputs this value via line 70 to the sample and hold circuit 62. The second counter 66 is clocked with the first clock signal CLK1 having a high frequency of e.g. 5 MHz. When the second counter 66 reaches the calculated switch on time $T_{ON*}$ it turns the power MOSFET 6 off by means of a driving circuit 71. The driving circuit 71 has an input connected to the counter 66 via a line 72 and an output connected to the power MOSFET 6 via a line 73. The switch on time $T_{ON}$ calculated by the calculation unit 63 controls the time period when the power MOSFET 6 is switched off and is used to determine when to sample the average current $I_{AVG*}$ for the following cycle in the sample and hold block 62. The switch on time $T_{ON*}$ can be calculated according to the following formula:

$$T_{ON}(k+1) = G*[I_{err}(k) - Z*I_{ERR}(k-1)] + T_{ON}(k) \qquad (4)$$

wherein

$$I_{ERR} = I_{DES} - I_{avg}$$

and G = Open loop gain of current regulation loop, Z= Zero Placement (0<z<1), $I_{DES}$ is the program average current value via SPI, $I_{avg}$ is the measured average current.

The regulation circuit as shown in figure 4 generates a current $I_{TS2}$ to follow continuously the current $T_{TS1}$ for the purpose of measuring the current $I_{T0}$ which flows through the inductive load 5 during the switch on time $T_{ON}$ of the power MOSFET 6. Since the inductive load 5 is linear the current $I_{T0}$ through the power MOSFET 6 on the on phase is always increasing with the constant slope.

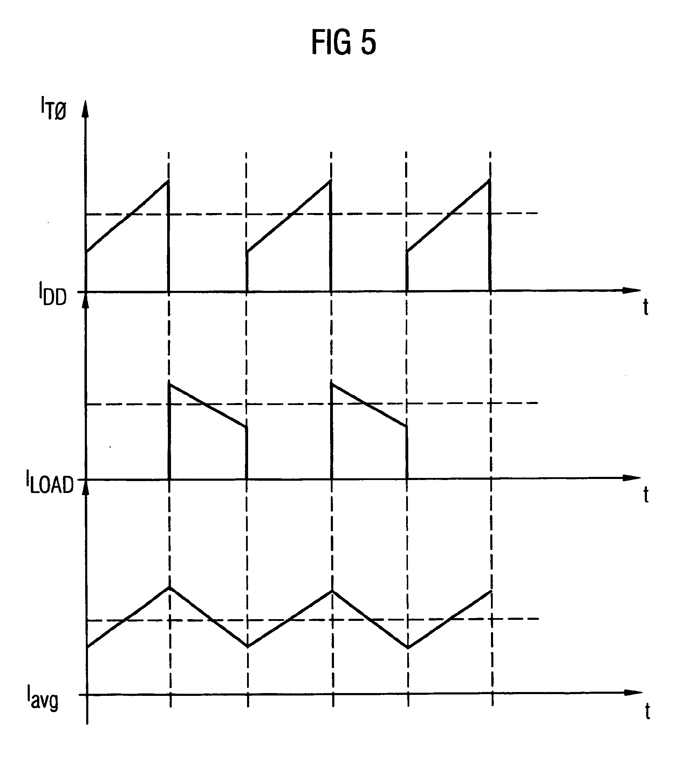

Figure 5 shows time diagrams of the currents flowing when a linear inductive load 5 is employed and the average current is regulated with the regulating circuit as shown in figure 4. The current $I_{Load}$ flowing through the linear inductive load 5 increases during the on phase of the power MOSFET 6 and decreases during the off phase of the power MOSFET 6. The current $I_{T0}$ going through the power MOSFET 6 increases during the ON phase $T_{ON}$ in a linear manner having a linear slope. Since the current going through the sense MOSFET $T_{S1}$ integrated in the power MOSFET 6 is proportional to the current $I_{T0}$ the average current $I_{Average}$ corresponds to the current $I_{TS2}$ following $I_{TS1}$ when $T_{ON}/2$ is reached. In this moment the sampling by the sample and hold circuit 62 is performed.

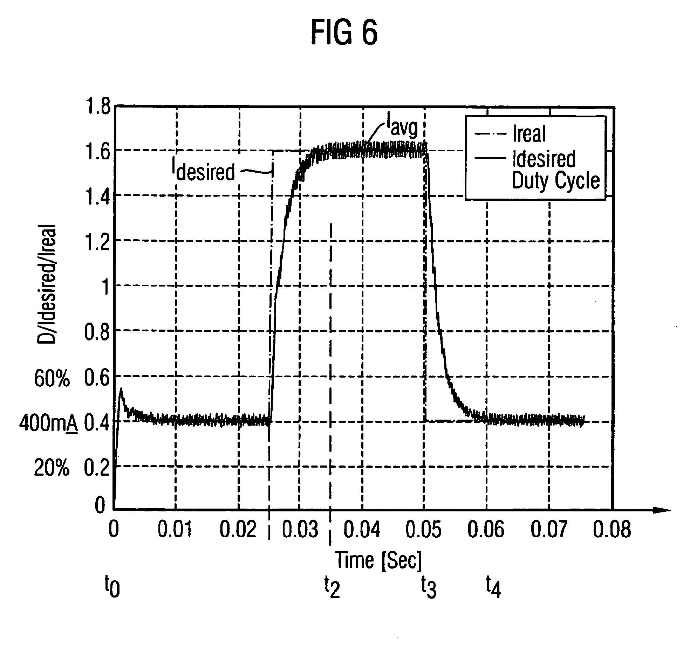

Figure 6 shows the regulation of the average current $I_{avg}$ to the inductive load 5 when changing the desired average current by means of the interface 65. As can be seen from figure 6 in the beginning at to the average current through the inductive load 5 is 400 mA and the duty cycle ($T_{ON}/T_{ON} + T_{OFF}$) is set to 20%. At $t_1$ a new desired average current of 1,6 A is set via the interface 65. The regulation circuit increases the duty cycle to 60% to reach the desired average current $I_{avg}$ of 1,6 A. As can be seen from figure 6 the regulator increases the average current $I_{AVG}$ to the desired average current $I_{Desired}$ within approximately 0,01 sec at t2. In the example shown in figure 6 the desired current is set back to 400 mA at $t_3$. The regulator sets the duty cycle back to 20% so that the average current $I_{AVG}$ reaches the desired value of 400 mA at $t_4$. The average current $I_{avg}$ set by the circuit shown in figure 4 is oscillating in a triangular manner as shown in figure 5.

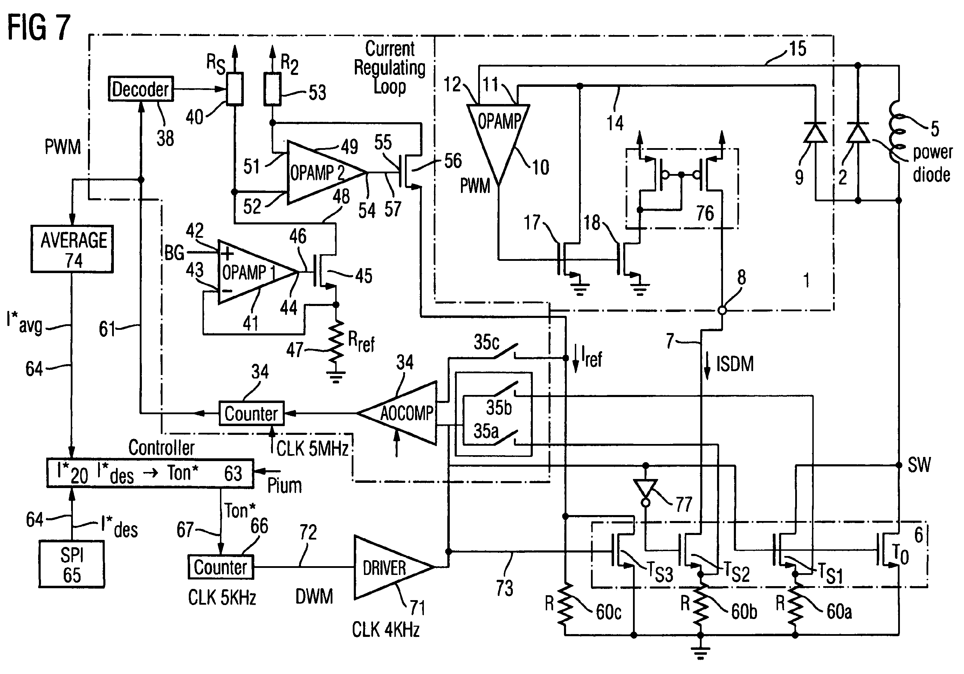

Figure 7 shows a regulating circuit for regulation the average current $I_{avg}$ through an inductive load 5 which is non linear. The regulation circuit as shown in figure 7 employs the current sensing circuit 1 according to the present invention.

The digital average current value $I^*_{avg}$ follows the current flowing through the switching transistor $T_0$ in the ON phase of this transistor and follows the current flowing through the power diode 2 during the OFF phase of the power MOSFET 6. An average calculating unit 74 calculates the average $I^*_{avg}$ between the actual digital current value $I^*_n$ and the previous digital current value $I^*_{n-1}$. In this manner the non linearities during the increase of the current $I_{T0}$ in the ON phase $T_{ON}$ caused by the non linear inductive load 5 are compensated. The current sensing circuit 1 according to the present invention is provided to sense the current flowing through the power diode 2 in the OFF phase of the switching MOSFET 6. This sensed current is mirrored by transistors 17, 18, 75, 76 and supplied to a third sensing transistor $T_{S3}$ integrated in the power MOSFET 6. The gate of $T_{S3}$ is connected via an inverter 77 to the output of driver circuit 71. When transistor $T_0$ is on $T_{S1}$ and $T_{S2}$ are also switched on to measure the current though $T_0$ in the on-phase. When $T_0$ is off then $T_{S3}$ is switched on to measure the current though $T_0$ in the off-phase. The circuit as shown in figure 7 makes it possible to sense a current $I_{T0}$ independently during the ON and OFF phase of the power MOSFET 6 in a very accurate manner. On the basis of the sensed current the average current $I_{avg}$ is sampled and used to calculate the $T_{ON}$ time or the duty cycle for the next cycle. Two sense currents are combined to achieve the highest accuracy possible. The sense diode current $I_{SD}$ is not transformed into a voltage by a simple resistor but by means of a matched resistor 60c and compared to another matched branch with an accurate. A dummy switch $35_c$ is provided for matching.

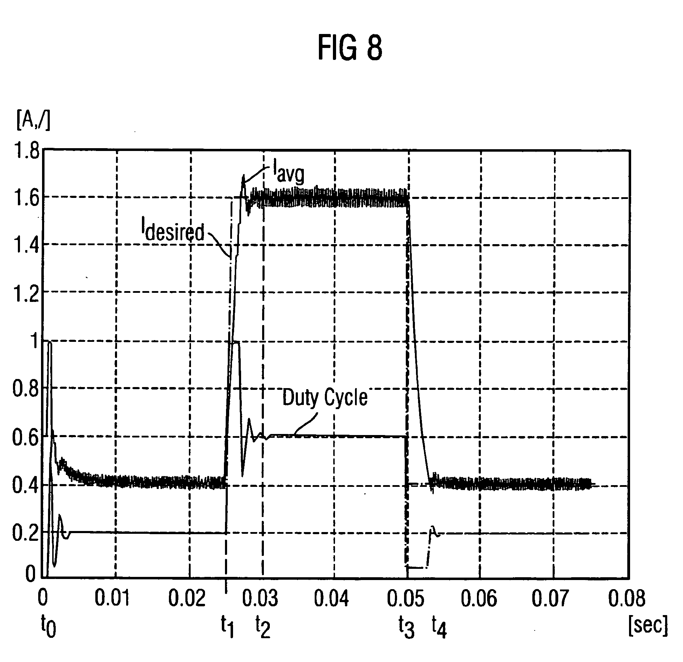

Figure 8 shows the timing diagram for the regulation circuit as shown in figure 7. When the desired average current $I_{avg}$ flowing through the non linear inductive load 5 is increased from 400 mA to 1.6 A at $t_1$ the current regulation provides an average current $I_{AVG}$ by increasing the duty cycle to 60% at $t_2$. When the desired average current $I_{avg}$ is set back to 400 mA at $t_3$ the actual average current is reached by the regulation at $t_4$.

**Claims**

1. Current sensing circuit for sensing a current flowing through a power diode (2) comprising:

   (a) a sense diode (9) matched with said power diode (2), wherein the sense diode (9) comprises an anode portion (9a) and a cathode portion (9b) and delivers a sense diode current ($I_{SD}$) which is proportional to the current ($I_{PD}$) flowing through said power diode (2);
   (b) an operational amplifier (10) having a first input (11) connected to the cathode portion (9b) of said sense diode (9) and a second input (12) connected to a cathode portion of the power diode (2) and having an output (13);
   (c) a current mirror circuit (14) for mirroring the sense diode current $I_{SD}$, wherein said current mirror circuit (14) comprises a first mirror transistor (14) and a second mirror transistor (18) each having a basis which is connected to the output (13) of said operational amplifier (10), wherein the collector of said first mirror transistor (14) is connected to the cathode portion (9b) of the sense diode (9) and wherein the collector of said second mirror transistor (18) delivers a mirrored sense diode current ($I_{SDM}$).

2. The current sensing circuit according to claim 1, wherein the power diode (2) comprises a plurality of power diode cells which are connected in parallel to each other.

3. The current sensing circuit according to claim 2, wherein the sense diode (9) is formed by at least one power diode cell.

4. The current sensing circuit according to claim 1, wherein the sense diode (9) is located close to the power diode (2) for matching.

5. The current sensing circuit according to claim 1, wherein the operational amplifier (10) is an Auto-Zero-Operational-Amplifier.

6. The current sensing circuit according to claim 1, wherein the emitters of said mirror transistors (17, 18) are connected via resistors (30, 31) to a reference potential.

7. The current sensing circuit according to claim 1, wherein the collectors of the mirror transistors (17, 18) are connected to cascode transistors (27, 28).

8. The current sensing circuit according to claim 7, wherein the cascode transistors each have a control terminal connected to a biasing voltage source (32).

9. The current sensing circuit according to claim 1, wherein the power diode (2) is a free wheeling power diode connected in parallel to an inductive load (5).

10. The current sensing circuit according to claim 9, wherein the inductive load (5) is connected to a switching power transistor (6).

11. The current sensing circuit according to claim 10 wherein the inductive load (5) is a linear inductive load.

12. The current sensing circuit according to claim 11, wherein the average current ($I_{AVG}$) flowing through the switching power transistor (6) is controlled by an average current control circuit which controls the duty cycle of said switching power transistor (6).

13. The current sensing circuit according to claim 12, wherein a first sensing transistor ($T_{S1}$) is integrated in said switching power transistor (6) for sensing the actual current ($I_{T0}$) flowing through said switching power transistor (6) in the ON phase.

14. The current sensing circuit according to claim 13, wherein a second sensing transistor ($T_{S2}$) is integrated in said switching power transistor (6).

15. The current sensing circuit according to claim 12, wherein the average current control circuit comprises a loop current regulating circuit (33) connected to said first sensing transistor ($T_{S1}$) and said second sensing transistor ($T_{S2}$).

16. The current sensing circuit according to claim 15, wherein the current regulating loop (33) comprises

    a comparator circuit (34) for comparing the current ($I_{TS1}$) flowing through said first sense transistor ($T_{S1}$) and the current ($I_{TS2}$) flowing through said second sense transistor ($T_{S2}$),
    a first counter (37) which counts up a digital counter value (I*) as long as the comparator circuit (34) indicates that the current ($I_{TS1}$) flowing through the first sense transistor ($T_{S1}$) is higher than the current ($I_{TS2}$) flowing through said second sense transistor ($T_{S2}$),
    a decoder (38) which decodes the digital counter value (I*) and generates a proportional DC voltage by adjusting a resistor (40) through which a reference current ($I_{REF}$) is flowing, and
    an operational amplifier (49) for generating in response to the DC voltage an output current ($I_{TS2}$) flowing to said second sense transistor ($T_{S2}$).

17. The current sensing circuit according to claim 16, wherein the first counter (37) is clocked with a clock signal (CLK) having a high clock frequency for oversampling.

18. The current sensing circuit according to claim 16, wherein the digital counter value (I*) output by said first counter (37) is sampled by a sample and hold circuit (62), wherein the sampled value represents the actual average current ($I_{AVG*}$) flowing through the switching power transistor (6) .

19. The current sensing circuit according to claim 16, wherein the sample and hold circuit (62) is clocked with a pulse with modulated (PWM) signal having a low clock frequency.

20. The current sensing circuit according to claim 1, wherein an interface (65) is provided for inputting a desired average current ($I_{Desired}$).

21. The current sensing circuit according to claim 20, wherein the actual average current ($I_{AVG*}$) which is sampled by said sample and hold circuit (62) and the desired average current ($I_{Desired*}$) which is input by means of said interface (65) are supplied to a calculation unit (63) which calculates the switch on time ($T_{ON*}$) for the switching power transistor (6) in response to the actual average current ($I_{AVG*}$) and the desired average current ($I_{Desired*}$).

22. The current sensing circuit according to claim 21, wherein a driver circuit (71) which is connected to a control terminal of the power transistor (6) turns the power transistor (6) off when a second counter (66) reaches the switch on time ($T_{ON*}$) calculated by said calculation unit (63).

23. The current sensing circuit according to claim 22, wherein said second counter (66) is clocked with the clock signal (CLK).

24. The current sensing circuit according to claim 9, wherein the inductive load (5) is a non linear inductive load.

25. The current sensing circuit according to claim 24, wherein during the ON phase of the switching power transistor (6) the actual current flowing through said power transistor (6) and through the inductive load (5) is sensed by said first sensing transistor ($T_{S1}$) and during the OFF phase of the switching power transistor (6) the actual current flowing through the inductive load (5) is sensed by a sense diode (2).

**Patentansprüche**

1. Stromfühlerschaltung zur Abfühlung eines durch eine Leistungsdiode (2) fließenden Stroms mit:

   (a) einer Fühlerdiode (9), welche der Leistungsdiode (2) angepasst ist, wobei die Fühlerdiode (9) einen Anodenabschnitt (9a) und einen Kathodenabschnitt (9b) aufweist und einen Fühlerdiodenstrom ($I_{SD}$) liefert, der proportional zu dem durch die Leistungsdiode (2) fließenden Strom ($I_{PD}$) ist;
   (b) einem Operationsverstärker (10) mit einem ersten Eingang (11), der mit dem Kathodenbereich (9b) der Fühlerdiode (9) verbunden ist, und mit einem zweiten Eingang (12), der mit einem Kathodenabschnitt der Leistungsdiode (2) verbunden ist, und mit einem Ausgang (13);
   (c) einer Stromspiegelschaltung (14) zur Spiegelung des Fühlerdiodenstroms $I_{SD}$, wobei die Stromspiegelschaltung (14) einen ersten Spiegeltransistor (17) und einen zweiten Spiegeltransistor (18) aufweist, von denen jeder eine Basis aufweist, die mit dem Ausgang (13) des Operationsverstärkers (10) verbunden ist,

   wobei der Kollektor des ersten Spiegeltransistors (17) mit dem Kathodenabschnitt (9b) der Fühlerdiode (9) verbunden ist, und
   wobei der Kollektor des zweiten Spiegeltransistors (18) einen gespiegelten Fühlerdiodenstrom ($I_{SDM}$) liefert.

2. Stromfühlerschaltung nach Anspruch 1,
   **wobei**
   die Leistungsdiode (2) eine Vielzahl von Leistungsdiodenzellen aufweist, welche parallel miteinander verbunden sind.

3. Stromfühlerschaltung nach Anspruch 2,
   **wobei**
   die Fühlerdiode (9) von mindestens einer Leistungsdiodenzelle gebildet ist.

4. Stromfühlerschaltung nach Anspruch 1,
   **wobei**
   die Fühlerdiode (9) dicht an der Leistungsdiode (2) angeordnet ist.

5. Stromfühlerschaltung nach Anspruch 1,
   **wobei**
   der Operationsverstärker (10) als ein Auto-Zero-Operationsverstärker ausgebildet ist.

6. Stromfühlerschaltung nach Anspruch 1,
   **wobei**
   die Emitter der Spiegeltransistoren (17, 18) über Widerstände (30, 31) mit einem Referenzpotenzial verbunden sind.

7. Stromfühlerschaltung nach Anspruch 1,
   wobei
   die Kollektoren der Spiegeltransistoren (17, 18) mit Kaskodentransistoren (27, 28) verbunden sind.

**8.** Stromfühlerschaltung nach Anspruch 7,
**wobei**
von den Kaskodentransistoren jeder einen Gateanschluss aufweist, der mit einer Spannungsquelle (32) zur Vorspannung verbunden ist.

**9.** Stromfühlerschaltung nach Anspruch 1,
**wobei**
die Leistungsdiode (2) eine Freilauf-Leistungsdiode ist, welche parallel zu einer induktiven Last (5) angeschlossen ist.

**10.** Stromfühlerschaltung nach Anspruch 9,
**wobei**
die induktive Last (5) mit einem Leistungsschalttransistor (6) verbunden ist.

**11.** Stromfühlerschaltung nach Anspruch 10,
**wobei**
die induktive Last (5) eine lineare induktive Last ist.

**12.** Stromfühlerschaltung nach Anspruch 11,
**wobei**
der durch den Leistungsschalttransistor (6) fließende Durchschnittsstrom ($I_{AVG}$) von einer Durchschnittsstromsteuerschaltung gesteuert, welche die Einschaltdauer des Leistungsschalttransistors (6) steuert.

**13.** Stromfühlerschaltung nach Anspruch 12,
**wobei**
ein erster Fühlertransistor ($T_{S1}$) in dem Leistungsschalttransistor (6) zur Abfühlung des aktuellen Stroms ($I_{T0}$) integriert, welcher durch den Leistungsschalttransistor (6) in der Einschaltphase fließt.

**14.** Stromfühlerschaltung nach Anspruch 13,
**wobei**
ein zweiter Fühlertransistor ($T_{S2}$) in dem Leistungsschalttransistor (6) integriert ist.

**15.** Stromfühlerschaltung nach Anspruch 12,
**wobei**
die Durchschnittsstromsteuerschaltung eine Schleifenstromregelschaltung (33) aufweist, welche mit dem ersten Fühlertransistor ($T_{S1}$) und mit dem zweiten Fühlertransistor ($T_{S2}$) verbunden ist.

**16.** Stromfühlerschaltung nach Anspruch 15,
**wobei**
die Stromregelschleife (33) Folgendes aufweist:

eine Komparatorschaltung (34) zum Vergleich des durch den ersten Fühlertransistor ($T_{S1}$) fließenden Stroms ($I_{TS1}$) und des durch den zweiten Fühlertransistor ($T_{S2}$) fließenden Stroms ($I_{TS2}$) ;
einen ersten Zähler (37), welcher einen digital Wert (I*) so lange aufwärts zählt wie die Komparatorschaltung (34) angibt, dass der durch den ersten Fühlertransistor ($T_{S1}$) fließende Strom ($I_{TS1}$) höher ist als der durch den zweiten Fühlertransistor ($T_{S2}$) fließende Strom ($I_{TS2}$) ;
einen Dekoder (38) zur Dekodierung des digitalen Zählerwerts (I*) und zur Erzeugung einer proportionalen DC-Spannung durch Einstellung eines Widerstands (40), durch welchen ein Referenzstrom ($I_{REF}$) fließt;
einen Operationsverstärker (49) zur Erzeugung eines zu dem zweiten Fühlertransistor ($T_{S2}$) fließenden Ausgabestroms ($I_{TS2}$) in Abhängigkeit von der DC-Spannung.

**17.** Stromfühlerschaltung nach Anspruch 16,
**wobei**
der erste Zähler (37) mit einem Taktsignal (CLK) getaktet ist, welches eine hohe Taktfrequenz für Oversampling aufweist.

**18.** Stromfühlerschaltung nach Anspruch 16,
**wobei**
der von dem ersten Zähler (37) ausgegebene digitale Zählerwert (I*) von einer Sample-And-Hold-Schaltung (62) abgefühlt bzw. gesampelt wird, wobei der abgefühlte Wert den aktuellen Durchschnittsstrom ($I_{AVG*}$) darstellt, der durch den Leistungsschalttransistor (6) fließt.

**19.** Stromfühlerschaltung nach Anspruch 16,
**wobei**
die Sample-And-Hold-Schaltung (62) mit einem Impuls mit moduliertem (PWM) Signal mit einer niedrigen Taktfrequenz getaktet ist.

**20.** Stromfühlerschaltung nach Anspruch 1,
**wobei**
ein Interface (65) zur Eingabe eines gewünschten bzw. Soll-Durchschnittsstroms ($I_{Desired}$) vorgesehen ist.

**21.** Stromfühlerschaltung nach Anspruch 20,
**wobei**
der aktuelle Durchschnittsstrom ($I_{AVG*}$), der von der Sample-And-Hold-Schaltung (62) abgefühlt bzw. gesampelt ist, und der Soll-Durchschnittsstrom ($I_{Desired*}$), der mittels des Interface (65) eingegeben ist, zu einer Berechnungseinheit (63) geliefert werden, welche die Einschaltzeit ($T_{ON*}$) für den Leistungsschalttransistor (6) in Abhängigkeit von dem aktuellen Durchschnittsstrom ($I_{AVG*}$) und dem Soll-Durchschnittsstrom ($I_{Desired}{}^*$) berechnet.

**22.** Stromfühlerschaltung nach Anspruch 21,
**wobei**
eine Treiberschaltung (71), welche mit einem Steueranschluss des Leistungsschalttransistors (6) verbunden ist, den Leistungsschalttransistor (6) ausschaltet, wenn ein zweiter Zähler (66) die von der Berechnungseinheit (63) berechnete Einschaltzeit ($T_{ON*}$) erreicht.

**23.** Stromfühlerschaltung nach Anspruch 22,
**wobei**
der zweite Zähler (66) mit dem Taktsignal (CLK) getaktet ist.

**24.** Stromfühlerschaltung nach Anspruch 9,
**wobei**
die induktive Last (5) eine nichtlineare induktive Last ist.

**25.** Stromfühlerschaltung nach Anspruch 24,
**wobei**
während der Einschaltphase des Leistungsschalttransistors (6) der durch den Leistungstransistor (6) und durch die induktive Last (5) fließende aktuelle Strom durch den ersten Fühlertransistor ($T_{S1}$) abgefühlt wird, und während der Ausschaltphase des Leistungsschalttransistors (6) der durch die induktive Last (5) fließende aktuelle Strom durch eine Fühlerdiode (9) abgefühlt wird.

**Revendications**

**1.** Circuit de détection de courant pour détecter un courant s'écoulant à travers une diode de puissance (2) comprenant :

(a) une diode de détection (9) adaptée à ladite diode de puissance (2),
dans lequel la diode de détection (9) comprend une partie anode (9a) et une partie cathode (9b) et délivre un courant de diode de détection ($I_{SD}$) qui est proportionnel au courant ($I_{PD}$) s'écoulant à travers ladite diode de puissance (2) ;
(b) un amplificateur opérationnel (10) ayant une première entrée (11) reliée à la partie cathode (9b) de ladite diode de détection (9) et une seconde entrée (12) reliée à une partie cathode de la diode de puissance (2) et ayant une sortie (13) ;
(c) un circuit miroir de courant (14) pour refléter le courant de diode de détection $I_{SD}$, dans lequel ledit circuit miroir de courant (14) comprend un premier transistor miroir (14) et un second transistor miroir (18), chacun ayant une base qui est reliée à la sortie (13) dudit amplificateur opérationnel (10),

dans lequel le collecteur dudit premier transistor miroir (14) est relié à la partie cathode (9b) de la diode de détection (9) et dans lequel le collecteur dudit second transistor miroir (18) délivre un courant de diode de détection reflété

($I_{SDM}$).

**2.** Circuit de détection de courant selon la revendication 1, dans lequel la diode de puissance (2) comprend une pluralité de cellules de diode de puissance qui sont reliées en parallèle les unes aux autres.

**3.** Circuit de détection de courant selon la revendication 2, dans lequel la diode de détection (9) est formée par au moins une cellule de diode de puissance.

**4.** Circuit de détection de courant selon la revendication 1, dans lequel la diode de détection (9) est située près de la diode de puissance (2) pour l'adaptation.

**5.** Circuit de détection de courant selon la revendication 1, dans lequel l'amplificateur opérationnel (10) est un amplificateur opérationnel à zéro automatique.

**6.** Circuit de détection de courant selon la revendication 1, dans lequel les émetteurs desdits transistors miroirs (17, 18) sont reliés par des résistances (30, 31) à un potentiel de référence.

**7.** Circuit de détection de courant selon la revendication 1, dans lequel les collecteurs des transistors miroirs (17, 18) sont reliés à des transistors cascode (27, 28).

**8.** Circuit de détection de courant selon la revendication 7, dans lequel les transistors cascode ont chacun une borne de commande reliée à une source de tension de polarisation (32).

**9.** Circuit de détection de courant selon la revendication 1, dans lequel la diode de puissance (2) est une diode de puissance de roue libre reliée en parallèle à une charge inductive (5).

**10.** Circuit de détection de courant selon la revendication 9, dans lequel la charge inductive (5) est reliée à un transistor de puissance de commutation (6).

**11.** Circuit de détection de courant selon la revendication 10, dans lequel la charge inductive (5) est une charge inductive linéaire.

**12.** Circuit de détection de courant selon la revendication 11, dans lequel le courant moyen ($I_{AVG}$) s'écoulant à travers le transistor de puissance de commutation (6) est commandé par un circuit de commande de courant moyen qui commande le rapport cyclique dudit transistor de puissance de commutation (6).

**13.** Circuit de détection de courant selon la revendication 12, dans lequel un premier transistor de détection ($T_{S1}$) est intégré dans ledit transistor de puissance de commutation (6) pour détecter le courant réel ($I_{T0}$) s'écoulant à travers ledit transistor de puissance de commutation (6) dans la phase MARCHE.

**14.** Circuit de détection de courant selon la revendication 13, dans lequel un second transistor de détection ($T_{S2}$) est intégré dans ledit transistor de puissance de commutation (6).

**15.** Circuit de détection de courant selon la revendication 12, dans lequel le circuit de commande de courant moyen comprend un circuit de régulation de courant à boucle (33) relié audit premier transistor de détection ($T_{S1}$) et audit second transistor de détection ($T_{S2}$).

**16.** Circuit de détection de courant selon la revendication 15, dans lequel la boucle de régulation de courant (33) comprend :

un circuit comparateur (34) pour comparer le courant ($I_{TS1}$) s'écoulant à travers ledit premier transistor de détection ($T_{S1}$) et le courant ($I_{TS2}$) s'écoulant à travers ledit second transistor de détection ($T_{S2}$),
un premier compteur (37) qui accumule une valeur de compteur numérique ($I^*$) tant que le circuit comparateur (34) indique que le courant ($I_{TS1}$) s'écoulant à travers le premier transistor de détection ($T_{S1}$) est supérieur au courant ($I_{TS2}$) s'écoulant à travers ledit second transistor de détection ($T_{S2}$),
un décodeur (38) qui décode la valeur de compteur numérique ($I^*$) et produit une tension continue proportionnelle en ajustant une résistance (40) à travers laquelle un courant de référence ($I_{REF}$) s'écoule, et
un amplificateur opérationnel (49) pour produire, en réponse à la tension continue, un courant de sortie ($I_{TS2}$)

s'écoulant vers ledit second transistor de détection ($T_{S2}$).

**17.** Circuit de détection de courant selon la revendication 16, dans lequel le premier compteur (37) est cadencé par un signal d'horloge (CLK) ayant une fréquence d'horloge élevée pour un suréchantillonnage.

**18.** Circuit de détection de courant selon la revendication 16,
dans lequel la valeur de compteur numérique (I*) sortie par ledit premier compteur (37) est échantillonnée par un circuit d'échantillonnage (62),
dans lequel la valeur échantillonnée représente le courant moyen réel ($I_{AVG}$*) s'écoulant à travers le transistor de puissance de commutation (6).

**19.** Circuit de détection de courant selon la revendication 16, dans lequel le circuit d'échantillonnage (62) est cadencé par un signal à modulation de largeur d'impulsion (PWM) ayant une fréquence d'horloge basse.

**20.** Circuit de détection de courant selon la revendication 1, dans lequel une interface (65) est prévue pour entrer un courant moyen souhaité ($I_{Desired}$).

**21.** Circuit de détection de courant selon la revendication 20, dans lequel le courant moyen réel ($I_{AVG}$*) qui est échantillonné par ledit circuit d'échantillonnage (62) et le courant moyen souhaité ($I_{Desired}$*) qui est l'entrée à l'aide de ladite interface (65) sont fournis à une unité de calcul (63) qui calcule le temps de mise à l'état passant ($T_{ON}$*) pour le transistor de puissance de commutation (6) en réponse au courant moyen réel ($I_{AVG}$*) et le courant moyen souhaité ($I_{Desired}$*).

**22.** Circuit de détection de courant selon la revendication 21, dans lequel un circuit de pilotage (71) qui est relié à une borne de commande du transistor de puissance (6) met le transistor de puissance (6) à l'état bloquant quand un second compteur (66) atteint le temps de mise à l'état passant ($T_{ON}$*) calculé par ladite unité de calcul (63).

**23.** Circuit de détection de courant selon la revendication 22, dans lequel ledit second compteur (66) est cadencé par le signal d'horloge (CLK).

**24.** Circuit de détection de courant selon la revendication 9, dans lequel la charge inductive (5) est une charge inductive non linéaire.

**25.** Circuit de détection de courant selon la revendication 24, dans lequel, pendant la phase MARCHE du transistor de puissance de commutation (6), le courant réel s'écoulant à travers ledit transistor de puissance (6) et à travers la charge inductive (5) est détecté par ledit premier transistor de détection ($T_{S1}$), et pendant la phase ARRÊT du transistor de puissance de commutation (6), le courant réel s'écoulant à travers la charge inductive (5) est détecté par une diode de détection (2).

# FIG 1

## Stand der Technik

# FIG 2

# FIG 3

FIG 4

EP 1 503 490 B1

# FIG 5

# FIG 6

FIG 7

# FIG 8